# EUROPEAN PATENT SPECIFICATION

(11) **EP 1 230 665 B1**
(45) Date of publication and mention of the grant of the patent: **22.10.2008**
(21) Application number: 00980409.7
(22) Date of filing: 14.11.2000
(51) Int. Cl.: H01J 37/32

(54) **PLASMA PROCESSING SYSTEM WITH DYNAMIC GAS DISTRIBUTION CONTROL**
PLASMABEHANDLUNGSVORRICHTUNG MIT DYNAMISCHER GASZUFÜHRSTEUERUNG
SYSTEME DE TRAITEMENT AU PLASMA A REGULATION DE DISTRIBUTION DE GAZ DYNAMIQUE

(30) Priority: 15.11.1999 US 470236
(43) Date of publication of application: 14.08.2002
(73) Proprietor: LAM RESEARCH CORPORATION, Fremont, CA 94538-6516 (US)
(72) Inventor: BAILEY, Andrew, D., III, Pleasanton, CA 94566 (US); SCHOEPP, Alan, M., Ben Lomond, CA 95005 (US); HEMKER, David, J., San Jose, CA 95127 (US); WILCOXSON, Mark, H., Piedmont, CA 94611 (US)
(74) Representative: Browne, Robin Forsythe
(86) International application number: PCT/US2000/031434
(87) International publication number: WO 2001/037317

(56) References cited:
- US-A- 4 989 544
- US-A- 5 522 934
- US-A- 5 810 932
- US-A- 6 132 552
- PATENT ABSTRACTS OF JAPAN vol. 1999, no. 07, 31 March 1999 (1999-03-31) & JP 09 139380 A (APPLIED MATERIALS INC), 27 May 1997 (1997-05-27) & US 6 022 446 A (DING JI ET AL) 8 February 2000 (2000-02-08)

## Description

### CROSS-REFERENCE TO RELATED CASES

This application is related to following concurrently filed U.S. Patent Applications: Application No.: 09/439,661 entitled "IMPROVED PLASMA PROCESSING SYSTEMS AND METHODS THEREFOR". (Attorney Docket No.: LAM1P122/P0527)
Application No.: 09/470,236 entitled "PLASMA PROCESSING SYSTEM WITH DYNAMIC GAS DISTRIBUTION CONTROL"; (Attorney Docket No.: LAM1P123/P0557)
Application No.: 09/439,675 entitled "TEMPERATURE CONTROL SYSTEM FOR PLASMA PROCESSING APPARATUS"; (Attorney Docket No.: LAM1P124/P0558)
Application No.: 09/440,418 entitled "METHOD AND APPARATUS FOR PRODUCING UNIFORM PROCESS RATES", (Attorney Docket No.: LAM1P125/P0560)
Application No.: 09/440,794 entitled "MATERIALS AND GAS CHEMISTRIES FOR PLASMA PROCESSING SYSTEMS", (Attorney Docket No.: LAM1P 128/P0561)
Application No.: 09/439,759 entitled "METHOD AND APPARATUS FOR CONTROLLING THE VOLUME OF PLASMA", (Attorney Docket No.: LAM1P129/P0593)

### BACKGROUND OF THE INVENTION

### Field of the Invention

The present invention relates to fabrication of semiconductor integrated circuits and, more particularly, to improved plasma processing systems for enhancing etch processes.

### Description of the Related Art

In the fabrication of semiconductor-based devices, e.g., integrated circuits or flat panel displays, layers of materials may alternately be deposited onto and etched from a substrate surface. During the fabrication process, various layers of material, e.g., borophosphosilicate glass (BPSG), polysilicon, metal, etc., are deposited on the substrate. The deposited layers may be patterned with known techniques, e.g., a photoresist process. Thereafter, portions of the deposited layers can be etched away to form various features, e.g., interconnect lines, vias, trenches, and etc.

The process of etching may be accomplished by a variety of known techniques, including plasma-enhanced etching. In plasma-enhanced etching, the actual etching typically takes place inside a plasma processing chamber. To form the desired pattern on the substrate wafer surface, an appropriate mask (e.g., a photoresist mask) is typically provided. With the substrate wafer in the plasma processing chamber, a plasma is then formed from suitable etchant source gas (or gases). The plasma is used to etch areas that are left unprotected by the mask, thereby forming the desired pattern. In this manner, portions of deposited layers are etched away to form interconnect lines, vias, trenches, and other features. The deposition and etching processes may be repeated until the desired circuit is obtained.

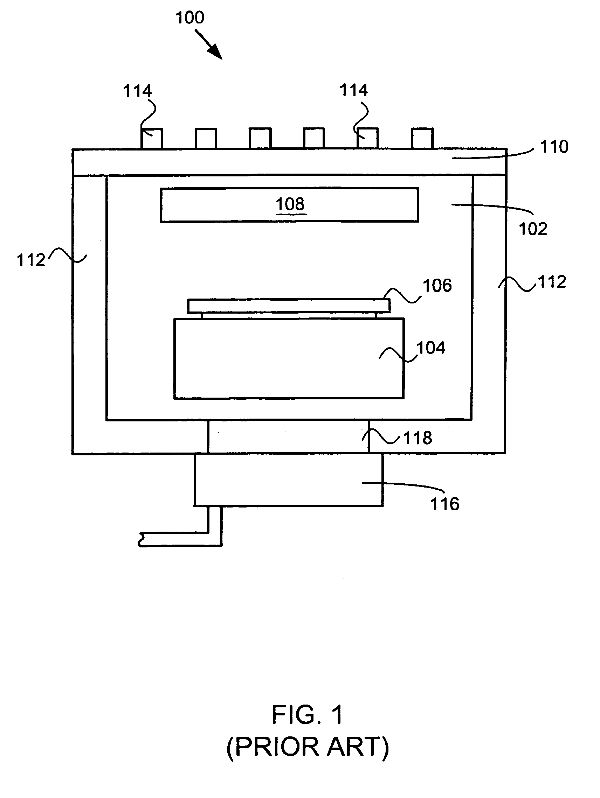

To facilitate discussion, FIG. 1 depicts a simplified plasma processing apparatus 100 suitable for fabrication of semiconductor-based devices. The simplified plasma processing apparatus 100 includes a plasma processing chamber 102 having an electrostatic chuck (ESC) 104. The chuck 104 acts as an electrode and supports a wafer 106 (i.e.. substrate) during fabrication. The surface of the wafer 106 is etched by an appropriate etchant source gas that is released into the wafer processing chamber 102. The etchant source gas can be released through a showerhead 108. The plasma processing source gas may also be released by other mechanisms such as through holes in a gas distribution plate. A vacuum plate 110 maintains a sealed contact with walls 112 of the wafer processing chamber 102. Coils 114 provided on the vacuum plate 110 are coupled to a radio frequency (RF) power source (not shown) and used to strike (ignite) a plasma from the plasma processing source gas released through the showerhead 108. The chuck 104 is also typically RF powered during the etch processes using a RF power supply (not shown). A pump 116 is also included to draw the process gases and gaseous products from the plasma processing chamber 102 through a duct 118.

As is known by those skilled in the art, in the case of etch processes, a number of parameters within the plasma processing chamber are tightly controlled to maintain high tolerance etch results. Gas composition, plasma excitation, and chamber conditions are process parameters that effect etch results. Since the etch tolerance (and resulting semiconductor-based device performance) is highly sensitive to such process parameters, accurate control thereof is required. To further elaborate, the etching process needs to be tightly controlled to achieve desirable etch characteristics, e.g., selectivity, etch uniformity, etch rate, etch profile, etc. Moreover, in modern integrated circuits controlling the etching process has gained even more significance. By way of example, as the features of modern integrated circuits have reduced in size, it has become increasingly more difficult to etch the desired features using conventional plasma processing systems with conventional methods. Thus, even tighter control of the etching process is needed for fabrication of modern integrated circuits.

In view of foregoing, there is a need for improved plasma processing systems that provide better control over the etching process.

Another example of a plasma etching system can be found in US-A-5 522 934. This paten application discloses a plurality of process gas supply nozzles. The nozzles are formed at several heights of the process chambers.

### SUMMARY OF THE INVENTION

Broadly speaking, the invention pertains to improved techniques for etch processing in a plasma processing system. In accordance with one aspect, the present invention can be utilized to enhance control of the etching process by a plasma processing system that includes a plasma processing chamber. The plasma processing chamber is connected to a gas flow system. The gas flow system can be employed to control the release of gases into the plasma processing chamber to multiple, different locations. Moreover, the gas flow system enables the control over the amount, volume or relative flow of gas released into the plasma processing chamber.

The present invention relates to a plasma etching system as defined in claim 1.

The invention can be implemented in numerous ways, including as a system, apparatus, machine, or method. Several embodiments of the invention are discussed below.

As a plasma processing system, one embodiment of the invention includes: a plasma processing chamber used to process a substrate; and a gas flow system coupled to the plasma processing chamber. The gas flow system controls flow of input gas into at least two different regions of the plasma processing chamber. As examples, at least two different regions can be selected from a top central region, an upper peripheral region, and a lower peripheral region.

As a plasma processing system, another embodiment of the invention includes: a substantially azimuthally symmetric cylindrical plasma processing chamber within which a plasma is both ignited and sustained for the processing, the plasma processing chamber having no separate plasma generation chamber, the plasma processing chamber having an upper end and a lower end; a coupling window disposed at an upper end of the plasma processing chamber; an RF antenna arrangement disposed above a plane defined by the substrate when the substrate is disposed within the plasma processing chamber for the processing; an electromagnet arrangement disposed above the plane defined by the substrate, the electromagnet arrangement being configured so as to result in a radial variation in the static magnetic field topology within the plasma processing chamber in the region proximate the RF antenna when at least one direct current is supplied to the electromagnet arrangement, the radial variation being effective to affect processing uniformity across the substrate; a dc power supply coupled to the electromagnet arrangement, the dc power supply having a controller to vary a magnitude of the at least one direct current, thereby changing the radial variation in the magnetic field topology within the plasma processing chamber in the region proximate the antenna to improve the processing uniformity across the substrate; and a gas flow system coupled to the plasma processing chamber, the gas flow system controlling flow of input gas into at least two different regions of the plasma processing chamber.

As a plasma processing system for processing a substrate, one embodiment of the invention includes: a substantially azimuthally symmetric plasma processing chamber within which a plasma is both ignited and sustained for the processing, the plasma processing chamber having no separate plasma generation chamber, the plasma processing chamber having an upper end and a lower end; a coupling window disposed at an upper end of the plasma processing chamber; an RF antenna arrangement disposed above a plane defined by the substrate when the substrate is disposed within the plasma processing chamber for the processing; an electromagnet arrangement disposed above the plane defined by the substrate, the electromagnet arrangement being configured so as to result in a radial variation in the static magnetic field strength and topology within the plasma processing chamber in the region proximate the RF antenna when at least one direct current is supplied to the electromagnet arrangement, the radial variation being effective to affect processing uniformity across the substrate; a dc power supply coupled to the electromagnet arrangement, the dc power supply having a controller to vary a magnitude of the at least one direct current, thereby changing the radial variation in the magnetic field topology within the plasma processing chamber in the region proximate the antenna to improve the processing uniformity across the substrate; and a gas flow system coupled to the plasma processing chamber, wherein the gas flow system controls the input gas is released into a first and a second region within the plasma processing chamber, the first region being a top central region within the plasma processing chamber and the second region being a peripheral region of the plasma processing chamber.

This invention has numerous advantages. Among other things, the present invention operates to enhance control over the distribution, e.g., uniformity of distribution of the neutral components. In addition, the present invention can be utilized to gain more control over the etch process without having to unnecessarily limit certain other parameters of the etch process, e.g., pressure, power deposition, material used in the etch process. Furthermore, the present invention provides the flexibly to vary the distribution of neutral components. The distribution of neutral components can be adjusted for different etch processes, as well as during different stage of the same etching process.

Other aspects and advantages of the invention will become apparent from the following detailed description, taken in conjunction with the accompanying drawings illustrating, by way of example, the principles of the invention.

### BRIEF DESCRIPTION OF THE DRAWINGS

The present invention will be readily understood by the following detailed description in conjunction with the accompanying drawings, wherein like reference numerals designate like structural elements, and in which:
Fig. 1 illustrates a plasma processing system suitable for etching a substrate.
Fig. 2 illustrates a plasma processing system including a gas flow system in accordance with one embodiment of the present invention.
Fig. 3 illustrates a plasma processing system including a gas flow system in accordance with another embodiment of the present invention.
Fig. 4 illustrates a plasma processing system including a gas flow system in accordance with yet another embodiment of the present invention.
Fig. 5 illustrates a plasma processing system including a magnetic arrangement in conjunction with a gas flow system in accordance with a particular embodiment of the present invention.

### DETAILED DESCRIPTION OF THE INVENTION

This invention pertains to improved apparatus and methods for etch processing in a plasma processing system. The invention enables improved control over injection of process gases into a plasma processing chamber. As a result, greater control over etch processing can be achieved which is becoming more and more important as feature sizes continue to get smaller. The invention also leads to reduction in defects on processed substrates and thus greater manufacturing yields.

Embodiments of this aspect of the invention are discussed below with reference to Figs. 1-5. However, those skilled in the art will readily appreciate that the detailed description given herein with respect to these figures is for explanatory purposes as the invention extends beyond these limited embodiments.

In one embodiment, a plasma processing system that includes a plasma processing chamber is disclosed. The plasma processing chamber is connected to a gas flow system. The gas flow system can be employed to control the release of gases into the plasma processing chamber. Input gas is received and delivered by the gas flow system to the plasma processing chamber. In accordance with a particular embodiment, input gas is delivered by two or more gas outlets of the gas flow system to the plasma processing chamber. Each gas outlet can deliver gas to a different desired region within the plasma processing system. In addition, the volume of the released gas, e.g., the flow rate of the gas, can be adjusted by the gas flow system. In this manner, both the position and the amount of the gas that is delivered into the plasma processing chamber can be controlled. The ability to adjust the position and the amount of gas that is released into the plasma processing chamber provides for better process control.

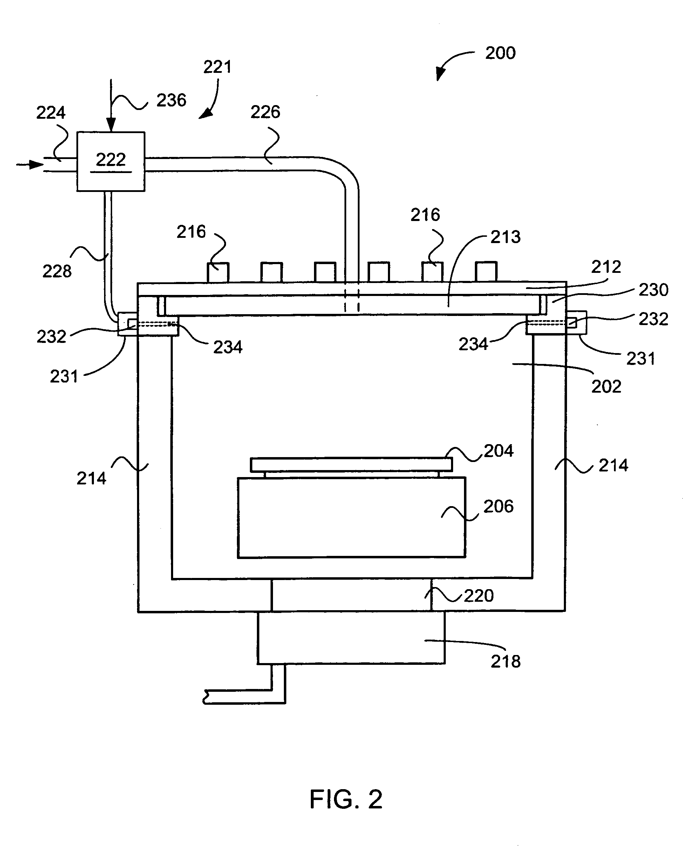

In semiconductor fabrication, features may be formed on a semiconductor wafer or substrate. More particularly, successive layers of various materials may be deposited on the semiconductor wafer or substrate. Thereafter, portions of selected deposited layers are etched away to form interconnect lines, trenches, and other features. To facilitate understanding of the present invention, FIG. 2 illustrates a plasma processing system 200 in accordance with one embodiment of the invention. The plasma processing system 200 includes a plasma processing chamber 202 having a wafer support mechanism, e.g., an electrostatic chuck (ESC) 206. A wafer (substrate) 204 is placed on the electrostatic chuck (ESC) 206 inside the plasma processing chamber 202. The ESC 206 can also be referred to as a bottom electrode that can be connected to a Radio Frequency (RF) powered source (not shown).

The surface of the wafer 206 is etched by an appropriate plasma processing source gas that is released into the plasma processing chamber 202. The source gas is a single input gas that contains a mixture of gases. The manner in which the plasma processing source gas is released into the plasma processing chamber 202 is discussed in more detail below. A vacuum plate 212 maintains a sealed contact with walls 214 of the wafer processing chamber 202. Coils 216 provided on the vacuum plate 212 are coupled to a radio frequency (RF) power source (not shown) and used to strike (ignite) a plasma from the plasma processing source gas released into the plasma processing chamber 202. The chuck 206 is also typically RF powered during the etch processes using an RF power supply (not shown). A pump 218 is also included to draw the process gases and gaseous products from the plasma processing chamber 202 through a duct 220.

The plasma processing system 200 includes a gas flow system 221 to control the delivery of the plasma processing source gases to the plasma processing chamber 202. The gas flow system 221 provides better control for releasing gas inside the plasma processing chamber 202. The gas flow system 221 includes a gas flow controller 222. The gas flow controller 222 receives source gas from a gas supply (not shown) through an inlet 224. The source gas contains a mixture of gases. The gas flow controller 222 also includes outlets 226 and 228 that supply the source gas to different locations of the plasma processing chamber 202 in a controlled fashion.

The gas outlets 226 and 228 can be connected to the plasma processing chamber 202 in a manner that source gas is delivered to different regions inside the plasma processing chamber 202. By way of example, as illustrated in Fig. 2, the outlet 226 can be configured to supply source gas to a top central region within the plasma processing chamber 202, and the outlet 228 can be configured to supply source gas to an upper peripheral region of the plasma processing chamber 202. Typically, the top central region is directly above the wafer 204, and the upper peripheral region is at the walls 214 near the vacuum plate 212.

To direct the source gas to the proper locations of the plasma processing chamber 202, the plasma processing chamber 202 can utilize other mechanisms. The source gas can be supplied to the top central region where an opening in the vacuum plate 212 is provided. The source gas is thus supplied from the source gas controller 222 through the outlet 226 and then through the opening and thus into the plasma processing chamber 202. The introduction of the source gas at the upper peripheral region of the plasma processing chamber 202 is more complicated. The plasma processing system 200 includes a ring 230 that is provided between the vacuum plate 212 and the upper surface of the walls 214 of the plasma processing chamber 202. Typically, a tight seal is provided between the ring 230 and the vacuum plate 212, as well as from the upper surface of the walls 214 and the ring 230. A gas channel housing 231 is provided integral with or coupled to the ring 230. The gas channel housing 231 forms a gas channel 232 that extends around the periphery of the plasma processing chamber 202. By way of example, in one particular embodiment, 16 openings (e.g., holes) are configured at an equal distance from each other. In addition, a series of holes 234 are provided in the ring 230. These holes 234 are provided substantially equidistant about the periphery of the ring 230 and provide openings between the gas channel 232 and the upper, internal areas of the plasma processing chamber 202. The outlet 228 supplies source gas to the gas channel 232 which in turn feeds source gas through all of the holes 234, thereby supplying source gas into the plasma processing chamber 202 about the periphery (or walls) of the plasma processing chamber 202. By way of example, in one particular embodiment, 16 openings, e.g., holes are configured at an equal distance from each other.

In addition to delivering gas to different regions within the plasma processing chamber, the gas flow system 221 can also control the amount (i.e., quantity or flow rate) of the gas that is delivered to different regions. To elaborate, the gas flow system 221 can be used to determine the amount of gas supplied to a particular region inside the processing chamber. In one embodiment, the gas flow controller 222 can control the flow of source gas through each of the outlets 226 and 228. By way of example, 70% of the total volume of source gas that is received by the gas flow controller 222 can be directed by one of the outlets (e.g., outlet 226) to a first region, while the remaining 30% of the total volume of source gas can be directed by the other outlets (e.g., outlet 228) to another region. Thus, the gas flow control mechanism can be adjusted so that outlets can deliver different volumes of gas to different regions. The flow controller 222 can be implemented by a variety of known mechanisms, e.g., a system of valves, to control the amount of gas that is delivered by each gas outlet. Further, the flow controller 222 is typically controlled by a control signal 236.

The input gas that is received by the inlet 224 is a mixture of gases that are previously combined together (e.g., pre-mixed). Alternatively, input gases can be supplied separately via two or more separate inlets, mixed at the flow controller 222, and then released as a mixture of gas into the plasma processing chamber 202 by the outlets 226, 228.

Typically, the inlet 224 receives a pre-mixed, mixture of gases with a particular gas flow rate ratio. By way of example, a mixture of a fluorocarbon gas and oxygen as the source gas can flow in the plasma processing chamber 202 via the flow controller 222 such that flow rate ratio of the fluorocarbon gas to the oxygen gas is 2 : 1. The gas flow system 221 can be configured to deliver the same gas mixture, i.e., with the same flow rate ratio, to multiple locations of the plasma processing chamber 202.

Thus, the gas flow system 221 allows input gases to be released to a desired region in a plasma processing chamber 202. Additionally, volume, e.g., flow rate, of gases that are released into that region can be adjusted by the gas flow system 221. Further, the gas flow system 221 provides the ability to adjust the relative flow rate ratios of different gases that are released into a plasma processing chamber. Furthermore, the amount, volume or relative flow of gas that is delivered to a particular region can be modified for different phases of the processing (e.g., etch processing). By way of example, the gas flow system 221 can set the flow rate for a plasma processing gas to one value for one stage of the etching process and then adjust the flow rate for the plasma processing gas during a subsequent state of the same etching process.

Although Fig. 2 illustrates the source gases being supplied to a top peripheral region as well as an upper peripheral region, in general, source gas can be supplied to multiple, different locations within a plasma processing chamber. As an example, source gas could be supplied to a lower peripheral region. Such source gas can be supplied into the plasma processing chamber through holes in the walls of the plasma processing chamber. As another example, gas can be supplied to a lower region around the substrate, e.g., near the edges of the wafer 204. By way of example, such source gas can be released by the ESC 206 near the edges of the wafer 204.

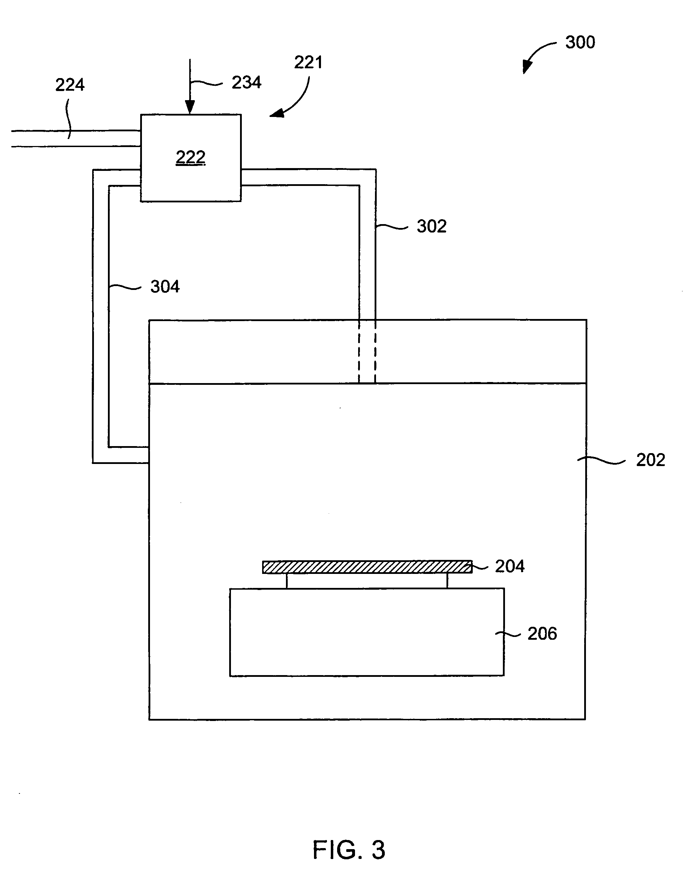

Fig. 3 depicts a simplified plasma processing system 300 suitable for delivery and release of input gases into a top peripheral region as well as lower peripheral region in accordance with another embodiment of the present invention. The plasma processing system 300 includes a gas flow system 221 to control the delivery of gas to the plasma processing chamber 202 as did the plasma processing chamber 200 of Fig.2. In this particular embodiment, the gas flow controller 222 includes outlet 302 that supplies source gas into a top central region of the plasma processing chamber 202 and an outlet 304 that supplies source gas to a lower peripheral region of the plasma processing chamber 202 in a controlled fashion.

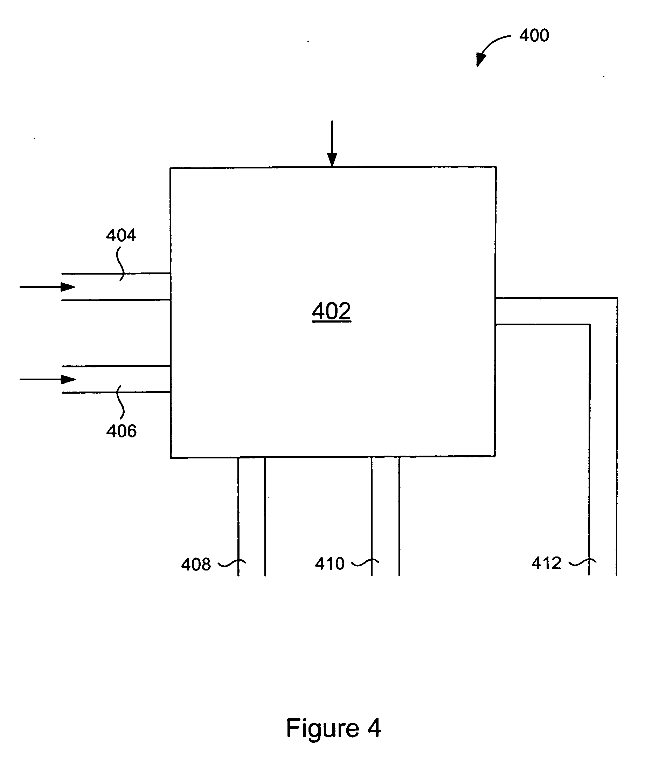

In addition, as will be apparent to those skilled in the art, if desired, more than two gas outlets can be utilized to deliver gas to a variety of different regions inside the plasma processing chamber. Fig. 4 illustrates a gas flow system 400 suitable for controlling the delivery of gas into a plasma processing chamber in accordance with another embodiment of the present invention. The gas flow system 400 includes a gas flow controller 402. The gas flow controller 402 can receive source gas through inlets 404 and 406. The source gas that is received by gas flow controller 402 can be a single gas or a mixture of gases. As shown in Fig. 4, the gas flow system 400 includes gas outlets 408, 410, and 412 which are suitable for delivery of gas into different regions of the plasma processing chamber in a controlled fashion. By way of example, the gas outlets 408, 410, and 412 can be utilized to supply gas into three different regions, e.g., a top central region, an upper peripheral region, and a lower peripheral region of the plasma processing chamber 202 in a controlled fashion. In addition, the gas flow system 402 is configured to provide the ability to adjust the amount of gas that is delivered to different regions by gas outlets 408, 410, and 412.

As shown in Fig. 4, two gas inlets (404 and 406) can be utilized to receive source gas that is delivered to different regions by gas outlets 408, 410, and 412. Each of gas inlets 404 and 406 can receive a different gas or a different combination of gases. It should be understood the values for gas flow rates and/or gas flow rate ratios that are released into a region can be different than those values that are received by the gas inlets 404 and 406. In other words, the gas flow system 400 provides the ability to determine and adjust the gas flow rates for release of gas into different regions of the plasma processing chamber. By way of example, the flow rate for release of gas into one region can be different than flow rate for release of gas into a different region. In addition, the flow rates for release of gas into one or all of the regions can be different than the flow rate at which the gas is received by the gas flow system 400. It should also be noted that although the gas flow system is configured to release gas into three regions, this does not necessarily mean that gas has be released into all of the region at any particular time during the etch process. By way example, the flow to gas outlet 408 can be completely shut off during a particular point in the etch process. The flow of gas into a region can be initiated or resumed at a later time during the etch process, and so forth.

The source gases can by supplied into the plasma processing chamber 202 by a variety of mechanisms. By way of example, the source gases can be supplied by a gas ring or openings such as ports or holes that are built into walls of the plasma processing chamber 102. It should also be noted that in plasma processing systems having a gas distribution plate (GDP), source gases can be delivered from a pattern of holes provided in the GDP. Regardless of how the source gas arrives within the plasma processing chamber 202 during the etching process, the source gases are then excited to strike a plasma. The surface of the wafer 204 is etched by the plasma. In one implementation, the source gases contain a mixture of a fluorocarbon and oxygen gases. In addition to such source gases, other gases can also flow in the plasma processing chamber 102. These other gases are typically mixed with the source gases but can be separate. For example, other gases, such as Argon, may be released into the plasma processing chamber 202 to serve as a dilutant, or a deposition precursor.

As it will be understood by those skilled in the art, the invention may be practiced in a number of other suitably arranged processing chambers. For example, the invention is applicable to processing chambers that deliver energy to the plasma through capacitively coupled parallel electrode plates, through inductively coupled RF sources such as helicon, helical resonators, and transformer coupled plasma (TCP). TCP plasma processing systems are available from Lam Research Corporation of Fremont, California. Other examples of suitable processing chambers include an inductive plasma source (IPS), a decoupled plasma source (DPS), and a dipole ring magnet (DRM).

As noted in the background, fabrication of modern integrated circuits continues to challenge those skilled in the art to gain better control over the etching process. By way of example, an important etching process parameter is the distribution of plasma inside the plasma processing chamber. To elaborate, as is known in the art, plasma processing conditions are associated with both charged and neutral components. As is well known, the charged components, e.g., positive and negative gas ions, significantly effect the etching process. The neutral components can also effect the etching process, e.g., some of the neutral gas components may react with the substrate wafer, other neutral components may stick to the walls of the processing chamber, etc. Thus, control over the distribution of the neutral plasma component is also desirable since it could significantly improve the etching process. In addition, it would be very desirable to provide for plasma processing systems and methods that are capable of enhancing control over the distribution of both the neutral and charged components. As is appreciated by those skilled in the art, the ability to control the distribution of both the neutral and charged components would significantly improve the etching process.

Furthermore, it is also desirable to gain better control over the distribution of plasma without having to limit certain etch processing parameters. To elaborate, certain parameters can effect the distribution of plasma components. These parameters include power profile, pressure at which the processing chamber operates, product specifications and sticking coefficients of various material that make up the wafer substrate. Although distribution of plasma components can be effected by one or more of these parameters, it would be disadvantageous to attempt to gain better control over the distribution of plasma by limiting these parameters. By way of example, limiting the materials that are used to form the wafer would be highly undesirable.

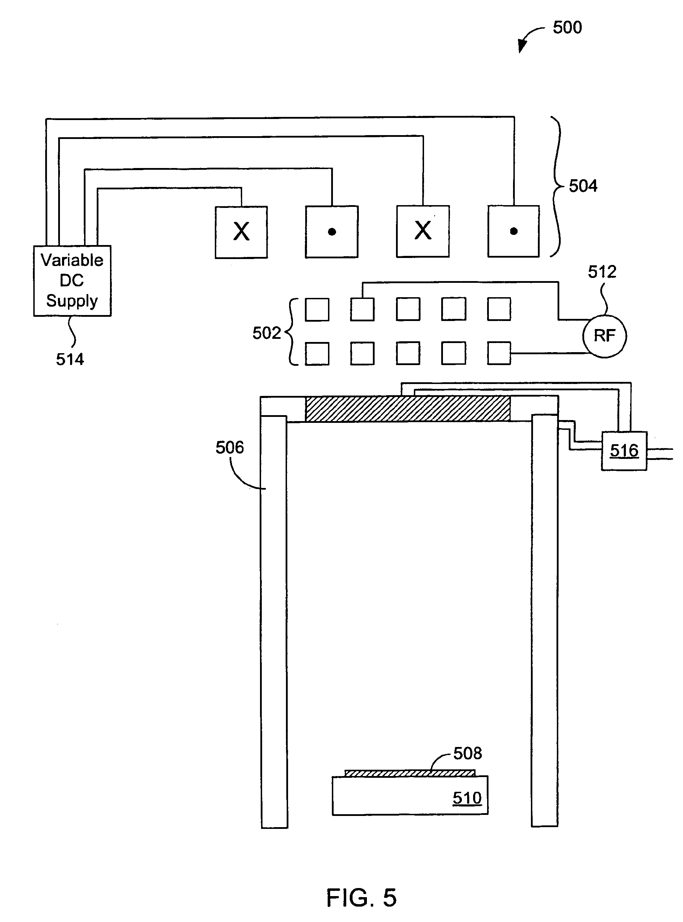

Fig. 5 illustrates, in accordance with yet another embodiment of the present invention, a plasma processing system 500 that is capable of providing better control over the distribution of both neutral and charged components. The plasma processing system 500 includes an exemplary RF antenna arrangement 502 and an exemplary upper magnet arrangement 504. In the example of Fig. 5, RF antenna arrangement 502 and upper magnet arrangement 504 are shown disposed above a plasma processing chamber 506. A wafer 500 is disposed on a chuck 510 inside the plasma processing chamber 506. As discussed in copending U.S. Patent Application No. 09/439,661 (Att. Dkt. No. LAM1P122), filed concurrently herewith, and entitled IMPROVED PLASMA PROCESSING SYSTEMS AND METHODS THEREFOR" (hereafter "referenced application"), other positions are also possible for RF antenna arrangement 502 and upper magnet arrangement 504.

RF antenna arrangement 502 is shown coupled to an RF power supply 512, which may supply RF antenna arrangement 502 with RF energy having a frequency in the range of about 0.4 MHz to about 50 MHz. In this particular embodiment, upper magnet arrangement 504 includes two concentric magnetic coils, both of which carry DC currents running in opposite directions. Upper magnet arrangement 504 is shown coupled to a variable Direct Current (DC) power supply 514, which is configured to vary the magnitude and/or direction of the direct current(s) supplied to the electromagnet coil(s) of upper magnet arrangement 504. It should be noted that other arrangements are also possible for plasma processing system 500. For example, magnetic buckets arrangements (not shown) may also be oriented around the outer periphery of the plasma processing chamber, as described in the referenced application.

The magnetic arrangement of the plasma processing system 500, or other magnetic arrangements as described in the referenced application, can significantly enhance etching process control. More particularly, among other things, the magnetic arrangement effects the distribution of charged components to provide more control over the plasma distribution. More control over the plasma distribution in turn enhances control over the etching process. Unfortunately, unlike the charged components, the neutral components do not significantly respond to magnetic fields.

As illustrated in Fig. 5, a gas flow system 516 can be used in conjunction with the magnetic arrangement 504. The gas flow system 516 can be utilized to provide more control over the distribution of neutral gas components. This in turn allows for further enhancement of control for the etch process. By way of example, gas flow system 516 can be utilized to deliver gas to different regions of the plasma processing chamber, e.g., in a similar manner as described with respect to the plasma processing system 200 shown in Fig. 2. In addition, the gas flow system 516 is configured to provide the ability to adjust the amount of gas that is delivered to a particular region. Thus, the use of the gas flow system 516 with a magnetic arrangement such as those described in the referenced application, can provide even more control of the etch process.

It is believed that distribution of neutral components can be effected by varying the time, e.g., mean time that input gases spent in the plasma processing chamber and/or the time, e.g., mean time that input gases spent in "hot zones". Hot zones as used herein, refer to the regions where input gases are excited. By way of example, input gases can be excited in regions that are near the top surfaces of the plasma processing chamber. By providing the ability to vary the location and the amount of gas that is delivered to the processing chamber, it is possible to adjust the time that neutral components spend in the plasma processing chamber and/or in the hot zones. By way of example, the mean time that is spend in the processing chamber is typically longer for a gas particles that are released into upper regions of the plasma processing chamber. In comparison, the mean time that is spend in the processing chamber is typically shorter for a gas that is released into a lower portion of the plasma processing since it is more likely that the gas would be quickly evacuated from the processing chamber.

This invention has numerous advantages. One advantage is that the present invention operates to enhance control over the distribution of neutral and/or plasma components to provide better control over the etching process. Another advantage is that more control over the etch process can be achieved without having to limit certain other parameters, e.g., pressure, power profile, etc. Yet another advantage is that the present invention can provide the flexibility to vary distribution of neutral and/or plasma components for different etch processes, as well as during different stages of the same etching process.

As it will be appreciated by those skilled in the art, the present invention can be utilized to form a variety of etched features such as contacts, via interconnection, , and etc. Further, as will be understood by those skilled in the art, the present invention can also be used in conjunction with a variety of particular etching techniques such as dual damascene, planarization, photoresist stripping, chamber cleaning, etc.

## Claims

1. A plasma etching system, said plasma etching system comprising:
a substantially cylindrical plasma processing chamber (202) configured for etching a semiconductor substrate (204), said substantially cylindrical plasma processing chamber including a top region located on the top surface of said substantially cylindrical plasma processing chamber and a peripheral region located on a side surface surrounding the periphery of said substantially cylindrical plasma processing chamber, said substantially cylindrical plasma processing chamber including at least an inner wall; and
a gas flow system (221) coupled to said plasma processing chamber, said gas flow system controlling flow of a single input gas comprising a mixture of etchant source gases into at least two different regions of said plasma processing chamber, said gas flow system comprising a gas inlet (224) for receiving said single input gas that is to be delivered into said plasma processing chamber and at least first and second gas outlets (226,228) configures to deliver the same said single input gas to at least two different regions including at least one peripheral region and at least one top region of said plasma processing chamber (202), at least a first portion of said input gas being delivered to said plasma processing chamber via said first outlet (226) and a remaining portion of said input gas being delivered to said plasma processing chamber via said second outlet (228), the first portion and the remaining portion of said input gas having the same mixture of etchant source gases so that said at least two different regions receive the same mixture of etchant source gases, the gas flow system (221) being configured to vary the amounts of first and remaining portions in order to control the distribution of neutral gas components inside the plasma processing chamber.

2. A plasma etching system as recited in claim 1, wherein the first region is a top central region and the second region is an upper peripheral region of the chamber.

3. A plasma etching system as recited in claim 2, wherein the at least two different regions further include a lower peripheral region.

4. A plasma etching system as recited in any preceding claim, wherein the at least two different regions include a lower region peripheral region near the substrate.

5. A plasma etching system as recited in any preceding claim, wherein the plasma etching system includes a chuck and the at least two different regions include a lower peripheral region near edges of the substrate, and
wherein the input gas is released through the chuck.

6. A plasma etching system as recited in any preceding claim, wherein said flow system controls the amount or volume of the single input gas into the at least two different regions of said plasma processing chamber.

7. A plasma etching system as recited in any preceding claim, wherein said flow system controls flow rate of the single input gas into the at least two different regions of said plasma processing chamber.

8. A plasma etching system as recited in any preceding claim, further comprising a gas delivery ring that is coupled to said plasma processing chamber, and
wherein said flow system controls the amount or volume of the single input gas to said gas delivery ring, thereby supplying the single input gas to the peripheral region of said plasma processing.

9. A plasma etching system as recited in claim 8, wherein said gas delivery ring is provided on an upper portion of the plasma processing chamber, thereby the gas delivery ring supplying the single input gas to the upper peripheral region of said plasma processing chamber.

10. A plasma etching system as recited in any preceding claim, wherein said plasma processing chamber includes at least an inner wall, and the gas flow system comprises:
at least one gas inlet for receiving the single input gas that is to be delivered into said plasma processing chamber;
at least first and second gas outlets that are capable of delivering the single input gas to the plasma etching system; and
wherein at least a portion of the single input gas is delivered to the plasma processing chamber via said first and second gas outlets.

11. A plasma etching system as recited in claim 10, wherein the at least a portion of the single input gas is released into the second region, and the single input gas that is released into the first region are delivered by the first gas outlet

12. A plasma etching system as recited in claim 10, wherein the at least a portion of the single input gas is released into the second region, and the single input gas that is released into the second region are delivered by the second gas outlet.

13. A plasma etching system as recited in claim 10, wherein the gas flow system receives a gas flow control signal for determining the amount or volume of the single input gas that is delivered into the plasma processing chamber by each one of the first and second gas outlets.

14. A plasma etching system as recited in claim 13, wherein the gas flow control signal determines the flow rate of delivery of the single input gas by each of the first and second gas outlets into the plasma processing chamber.

15. The plasma etching system as recited in any preceding claim, wherein the plasma processing chamber is a substantially cylindrical plasma processing chamber within which a plasma is both ignited and sustained for said etching, said plasma processing chamber having no separate plasma generation chamber, said plasma processing chamber having an upper end and a lower end;
further comprising;
a coupling window disposed at an upper end of said plasma processing chamber;
an RF antenna arrangement disposed above a plane defined by said substrate when said substrate is disposed within said plasma processing chamber for said etching;
an electromagnetic arrangement disposed above said plane defined by said substrate, said electromagnetic arrangement being configured so as to result in a radial variation in the static magnetic field topology within said plasma processing chamber in the region promixate said RF antenna when at least one direct current is supplied to said electromagnet arrangement, said radial variation being effective to affect processing uniformity across said substrate; and
a dc power supply coupled to said electromagnet arrangement, said dc power supply having a controller to vary a magnitude of said at least one direct current, thereby changing said radial variation in said magnetic field topology within said plasma processing chamber in said region proximate said antenna to improve said processing uniformity across said substrate.

16. A plasma etching system as recited in claim 15, wherein said flow system controls flow rate of the single input gas into the at least two different regions of said plasma processing chamber.

## Patentansprüche

1. Plasmaätzanlage, wobei die Plasmaätzanlage aufweist:
eine im Wesentlichen zylindrische Plasmaprozesskammer (202), die zum Ätzen eines Halbleitersubstrats (204) konfiguriert ist, wobei die im Wesentlichen zylindrische Plasmaprozesskammer einen oberen Bereich beinhaltet, der auf der oberen Oberfläche der im Wesentlichen zylindrischen Plasmaprozesskammer angeordnet ist, und einen peripheren Bereich, der auf einer seitlichen Oberfläche, die die Peripherie der im Wesentlichen zylindrischen Plasmaprozesskammer umgibt, wobei die im Wesentlichen zylindrische Plasmaprozesskammer zumindest eine Innenwand beinhaltet; und
ein Gas-Strömungssystem (221), das mit der Plasmaprozesskammer gekoppelt ist, wobei das Gas-Strömungssystem den Fluss eines einzelnen Eingabegases, das ein Gemisch von ätzenden Quellgasen aufweist, in mindestens zwei unterschiedliche Bereiche der Plasmaprozesskammer steuert, wobei das Gas-Strömungssystem aufweist: einen Gaseinlass (224) zum Aufnehmen des einzelnen Eingabegases, das in die Plasmaprozesskammer zu liefern ist, und mindestens erste und zweite Gasauslässe (226, 228), die derart konfiguriert sind, dass sie das gleiche einzelne Eingabegas zu mindestens zwei unterschiedlichen Bereichen liefern, die mindestens einen peripheren Bereich und mindestens einen oberen Bereich der Plasmaprozesskammer (202) beinhalten, mindestens einen ersten Anteil des Eingabegases, das über den ersten Auslass (226) zu der Plasmaprozesskammer geliefert wird, und einen restlichen Anteil des Eingabegases, das über den zweiten Auslass (228) zu der Plasmaprozesskammer geliefert wird, wobei der erste Anteil und der restliche Anteil des Eingabegases das gleiche Gemisch des ätzenden Quellgases aufweisen, so dass mindestens zwei unterschiedliche Bereiche das gleiche Gemisch der ätzenden Quellgase aufnehmen, wobei das Gas-Strömungssystem (221) derart konfiguriert ist, dass sie die Menge des ersten und des restlichen Anteils variiert, um die Verteilung von neutralen Gaskomponenten innerhalb der Plasmaprozesskammer zu steuern.

2. Plasmaätzanlage nach Anspruch 1, wobei der erste Bereich ein oberer, mittiger Bereich und der zweite Bereich ein oberer, peripherer Bereich der Kammer ist.

3. Plasmaätzanlage nach Anspruch 2, wobei die mindestens zwei unterschiedlichen Bereiche ferner einen unteren, peripheren Bereich beinhalten.

4. Plasmaätzanlage nach einem der vorhergehenden Ansprüche, wobei die mindestens zwei unterschiedlichen Bereiche einen unteren Bereich, peripheren Bereich in der Nähe des Substrats beinhalten.

5. Plasmaätzanlage nach einem der vorhergehenden Ansprüche, wobei die Plasmaätzanlage eine Spannvorrichtung beinhaltet, und die mindestens zwei unterschiedlichen Bereiche einen unteren, peripheren Bereich in der Nähe der Kanten des Substrats aufweisen, und wobei das Eingabegas durch die Spannvorrichtung freigegeben wird.

6. Plasmaätzanlage nach einem der vorhergehenden Ansprüche, wobei die Strömungsanlage die Menge oder das Volumen des einzelnen Eingabegases in die mindestens zwei unterschiedlichen Bereiche der Plasmaprozesskammer steuert.

7. Plasmaätzanlage nach einem der vorhergehenden Ansprüche, wobei das Strömungssystem die Durchflussrate des einzelnen Eingabegases in die mindestens zwei unterschiedlichen Bereiche der Plasmaprozesskammer steuert.

8. Plasmaätzanlage nach einem der vorhergehenden Ansprüche, ferner aufweisend einen Gaslieferring, der mit der Plasmaprozesskammer gekoppelt ist, und
wobei das Strömungssystem die Menge oder das Volumen des einzelnen Eingabegases zu dem Gaslieferring steuert, wodurch das einzelne Eingabegas dem peripheren Bereich der Plasmaverarbeitung zugeführt wird.

9. Plasmaätzanlage nach Anspruch 8, wobei der Gaslieferring auf einem oberen Abschnitt der Plasmaprozesskammer vorgesehen ist, wodurch der Gaslieferring das einzelne Eingabegas dem oberen peripheren Bereich der Plasmaprozesskammer zuführt.

10. Plasmaätzanlage nach einem der vorhergehenden Ansprüche, wobei die Plasmaprozesskammer zumindest eine Innenwand beinhaltet und das Gas-Strömungssystem aufweist:
mindestens einen Gaseinlass zum Aufnehmen des einzelnen Eingabegases, das in die Plasmaprozesskammer zu liefern ist;
mindestens erste und zweite Gasauslässe, die in der Lage sind, das einzelne Eingabegas zu der Plasmaätzanlage zu liefern; und
wobei mindestens ein Anteil des einzelnen Eingabegases über die ersten und zweiten Gasauslässe zu der Plasmaprozesskammer geliefert wird.

11. Plasmaätzanlage nach Anspruch 10, wobei der mindestens eine Anteil des einzelnen Eingabegases in den zweiten Bereich freigegeben wird, und das einzelne Eingabegas, das in den ersten Bereich freigegeben ist, durch den ersten Gasauslass geliefert wird.

12. Plasmaätzanlage nach Anspruch 10, wobei der mindestens eine Anteil des einzelnen Eingabegases in den zweiten Bereich freigegeben wird, und das einzelne Eingabegas, das in den zweiten Bereich freigegeben ist, durch den zweiten Gasauslass geliefert wird.

13. Plasmaätzanlage nach Anspruch 10, wobei das Gas-Strömungssystem ein Gasströmungssteuersignal zum Bestimmen der Menge oder des Volumens des einzelnen Eingabegases, das durch jeden ersten und zweiten Gasauslass in die Plasmaprozesskammer geliefert wird, empfängt.

14. Plasmaätzanlage nach Anspruch 13, wobei das Gasströmungssteuersignal die Durchflussrate des gelieferten einzelnen Eingabegases durch jeden der ersten und zweiten Gasauslässe in die Plasmaprozesskammer bestimmt.

15. Plasmaätzanlage nach einem der vorhergehenden Ansprüche, wobei die Plasmaprozesskammer im Wesentlichen eine zylindrische Plasmaprozesskammer ist, innerhalb der ein Plasma sowohl gezündet als auch zum Ätzen gehalten wird, wobei die Plasmaprozesskammer keine separate Plasmaerzeugungskammer aufweist, wobei die Plasmaprozesskammer ein oberes Ende und ein unteres Ende aufweist;
ferner aufweisend;
ein Koppelfenster, das an einem oberen Ende der Plasmaprozesskammer angeordnet ist;
eine RF-Antennenanordnung, die oberhalb einer Ebene angeordnet ist, die durch das Substrat definiert ist, wenn das Substrat zum Ätzen innerhalb der Plasmaprozesskammer angeordnet ist;
eine elektromagnetische Anordnung, die oberhalb der Ebene angeordnet ist, die durch das Substrat definiert ist, wobei die elektromagnetische Anordnung derart konfiguriert ist, dass sie eine radiale Veränderung in der statischen Magnetfeldtopologie innerhalb der Plasmaprozesskammer im Bereich, der in der Nähe der RF-Antenne ist, zur Folge hat, wenn mindestens ein Gleichstrom der elektromagnetischen Anordnung zugeführt wird, wobei die radiale Veränderung derart wirksam ist, dass sie die Prozessgleichmäßigkeit über das Substrat beeinflusst; und
eine Gleichstromversorgung, die mit der elektromagnetischen Anordnung gekoppelt ist, wobei die Gleichstromversorgung ein Steuergerät aufweist, so dass es eine Größe des mindestens einen Gleichstroms variiert, wodurch die radiale Veränderung in der Magnetfeldtopologie innerhalb der Plasmaprozesskammer im Bereich, der in der Nähe der Antenne ist, verändert wird, so dass die Prozessgleichmäßigkeit über das Substrat verbessert wird.

16. Plasmaätzanlage nach Anspruch 15, wobei das Strömungssystem den Durchfluss des einzelnen Eingabegases in die mindestens zwei unterschiedlichen Bereiche der Plasmaprozesskammer steuert.

## Revendications

1. Système de gravure chimique au plasma, le système de gravure chimique au plasma comprenant :
une chambre de traitement au plasma sensiblement cylindrique (202) conçue pour graver un substrat de semi-conducteur (204), ladite chambre de traitement au plasma sensiblement cylindrique comprenant une région supérieure située sur la surface supérieure de ladite chambre de traitement au plasma sensiblement cylindrique et une région périphérique située sur une surface latérale entourant la périphérie de ladite chambre de traitement au plasma sensiblement cylindrique, ladite chambre de traitement au plasma sensiblement cylindrique comprenant au moins une paroi interne ; et
un système d'écoulement de gaz (221) couplé à ladite chambre de traitement au plasma, ledit système d'écoulement de gaz contrôlant l'écoulement d'un simple gaz d'entrée comprenant un mélange de gaz sources de gravure chimique vers au moins deux régions différentes de ladite chambre de traitement au plasma, ledit système d'écoulement de gaz comprenant une entrée de gaz (224) pour recevoir ledit simple gaz d'entrée qui doit être introduit dans ladite chambre de traitement au plasma et au moins une première et une seconde sortie de gaz (226, 228) conçues pour introduire ledit simple gaz d'entrée dans au moins deux régions différentes comprenant au moins une région périphérique et au moins une région supérieure de ladite chambre de traitement au plasma (202), au moins une première portion dudit gaz d'entrée étant introduite dans ladite chambre de traitement au plasma par l'intermédiaire de ladite première sortie (226) et la portion restante dudit gaz d'entrée étant introduite dans ladite chambre de traitement au plasma par l'intermédiaire de ladite seconde sortie (228), la première portion et la portion restante dudit gaz d'entrée étant constituées du même mélange de gaz sources de gravure chimique, de façon à ce que lesdites au moins deux régions reçoivent le même mélange de gaz sources de gravure chimique, le système d'écoulement de gaz (221) étant conçu pour faire varier les quantités de la première portion et de la portion restante afin de contrôler la répartition des composants gazeux neutres à l'intérieur de la chambre de traitement au plasma.

2. Système de gravure chimique au plasma selon la revendication 1, dans lequel la première région est une région centrale supérieure et la seconde région est une région périphérique supérieure de la chambre.

3. Système de gravure chimique au plasma selon la revendication 2, dans lequel les au moins deux régions différentes comprennent en outre une région périphérique inférieure.

4. Système de gravure chimique au plasma selon l'une des revendications précédentes, dans lequel les au moins deux régions différentes comprennent une région périphérique inférieure à proximité du substrat.

5. Système de gravure chimique au plasma selon l'une des revendications précédentes, dans lequel le système de gravure chimique au plasma comprend un mandrin et les au moins deux régions différentes comprennent une région périphérique inférieure à proximité des bords du substrat, et dans lequel le gaz d'entrée est libéré à travers le mandrin.

6. Système de gravure chimique au plasma selon l'une des revendications précédentes, dans lequel ledit système d'écoulement de gaz contrôle la quantité ou le volume de simple gaz d'entrée dans les au moins deux régions différentes de ladite chambre de traitement au plasma.

7. Système de gravure chimique au plasma selon l'une des revendications précédentes, dans lequel ledit système d'écoulement de gaz contrôle le débit du simple gaz d'entrée dans les au moins deux régions différentes de ladite chambre de traitement au plasma.

8. Système de gravure chimique au plasma selon l'une des revendications précédentes, comprenant en outre une bague d'alimentation en gaz couplée à ladite chambre de traitement au plasma et dans lequel ledit système d'écoulement de gaz contrôle la quantité ou le volume de simple gaz d'entrée vers la bague d'alimentation en gaz, introduisant ainsi le simple gaz d'entrée dans la région périphérique de ladite chambre de traitement au plasma.

9. Système de gravure chimique au plasma selon la revendication 8, dans lequel ladite bague d'alimentation en gaz se trouve sur une portion supérieure de la chambre de traitement au plasma, la bague d'alimentation en gaz introduisant ainsi le simple gaz d'entrée dans la région périphérique supérieure de ladite chambre de traitement au plasma.

10. Système de gravure chimique au plasma selon l'une des revendications précédentes, dans lequel ladite chambre de traitement au plasma comprend au moins une paroi interne et le système d'écoulement de gaz comprend :
au moins une entrée de gaz pour recevoir le simple gaz d'entrée qui doit être introduit dans ladite chambre de traitement au plasma ;
au moins une première sortie de gaz et une seconde sortie de gaz capables d'introduire le simple gaz d'entrée dans le système de gravure chimique au plasma ; et
dans lequel au moins une portion du simple gaz d'entrée est introduite dans la chambre de traitement au plasma par l'intermédiaire de ladite première sortie de gaz et de ladite seconde sortie de gaz.

11. Système de gravure chimique au plasma selon la revendication 10, dans lequel la au moins une portion du simple gaz d'entrée est libérée dans la seconde région et le simple gaz d'entrée qui est libéré dans la première région est introduit par la première sortie de gaz.

12. Système de gravure chimique au plasma selon la revendication 10, dans lequel la au moins une portion de simple gaz d'entrée est libérée dans la seconde région et le simple gaz d'entrée qui est libéré dans la première région est introduit par la seconde sortie de gaz.

13. Système de gravure chimique au plasma selon la revendication 10, dans lequel le système d'écoulement de gaz reçoit un signal de contrôle d'écoulement de gaz permettant de déterminer la quantité ou le volume de simple gaz d'entrée qui est introduite dans la chambre de traitement au plasma par chacune des première et seconde sorties de gaz.

14. Système de gravure chimique au plasma selon la revendication 13, dans lequel le signal de contrôle d'écoulement de gaz détermine le débit d'introduction du simple gaz d'entrée par chacune des première et seconde sorties de gaz dans la chambre de traitement au plasma.

15. Système de gravure chimique au plasma selon l'une des revendications précédentes, dans lequel la chambre de traitement au plasma est une chambre de traitement au plasma sensiblement cylindrique à l'intérieur de laquelle un plasma est allumé et maintenu pour ladite gravure chimique, ladite chambre de traitement au plasma ne possédant pas de chambre de génération de plasma séparée, ladite chambre de traitement au plasma ayant une extrémité supérieure et une extrémité inférieure ;
comprenant en outre :
une fenêtre de couplage disposée au niveau d'une extrémité supérieure de ladite chambre de traitement au plasma ;
un dispositif à antenne RF disposé au-dessus d'un plan défini par ledit substrat lorsque ledit substrat est disposé à l'intérieur de ladite chambre de traitement au plasma pour ladite gravure chimique ;
un dispositif électromagnétique disposé au-dessus dudit plan défini par ledit substrat, ledit dispositif électromagnétique étant conçu de façon à provoquer une variation radiale de la topologie du champ magnétique statique à l'intérieur de ladite chambre de traitement au plasma dans la région proche de ladite antenne RF lorsqu'au moins un courant continu est appliqué audit dispositif électromagnétique, ladite variation radiale influençant l'uniformité du traitement sur ledit substrat ; et
une alimentation en courant continu couplée audit dispositif électromagnétique, ladite alimentation en courant continu comprenant un contrôleur permettant de modifier une amplitude dudit au moins un courant continu, modifiant ainsi ladite variation radiale de ladite topologie du champ magnétique à l'intérieur de ladite chambre de traitement au plasma dans ladite région proche de ladite antenne afin d'améliorer ladite uniformité du traitement sur ledit substrat.

16. Système de gravure chimique au plasma selon la revendication 15, dans lequel ledit système d'écoulement contrôle le débit du simple gaz d'entrée vers les au moins deux régions différentes de ladite chambre de traitement au plasma.
